# EUROPEAN PATENT APPLICATION

(11) **EP 0 641 018 A1**
(43) Date of publication of application: **01.03.1995**
(21) Application number: 94113082.5
(22) Date of filing: 22.08.1994
(51) Int. Cl.: H01L 21/20, H01L 21/336

(54) **Manufacturing method of semiconductor device and thin film transistor with a recrystallized thin semiconductor film**

(30) Priority: 23.08.1993 JP 208024/93
(71) Applicant: MATSUSHITA ELECTRIC INDUSTRIAL CO., LTD., Kadoma-shi, Osaka-fu, 571 (JP)
(72) Inventor: Yoshioka, Tatsuo, Korien Hirakata-shi, Osaka 573 (JP); Tetsuya, Kawamura, Hirakata-shi, Osaka 573 (JP); Furuta, Mamoru, Hirakata-shi, Osaka 573-01 (JP); Miyata, Yutaka, Ikoma-shi, Nara 630-01 (JP)
(74) Representative: Grünecker, Kinkeldey, Stockmair & Schwanhäusser Anwaltssozietät

(57) **Abstract**

A semiconductor device, e.g. a TFT, is made by recrystallizing a thin silicon film (4) the thickness of which is comprised between 50 Å and 250 Å, deposited on a light fermeable substrate (1). The recrystallizing step is a excimer laser one.

## Description

### Back Ground of the Invention

### 1.Industrial Field of Utilization of the Invention

The present invention relates to a manufacturing method of semiconductor device for forming a thin film transistor (TFT) on a light permeable substrate, and a TFT fabricated by the same manufacturing method.

### 2.Related Art of the Invention

In a TFT using a polycrystalline silicon as semiconductor layer, the polycrystalline silicon is formed by a method of depositing a polycrystalline silicon thin film directly on a substrate made of quartz or the like at a temperature of 600°C or more by LPCVD (low-pressure chemical vapor deposition) method or the like, a method of forming a polycrystalline silicon by solid phase growth of hydrogenated amorphous silicon thin film, fine crystalline silicon thin film or the like at a temperature of 600°C or more, and a method of forming a polycrystalline thin film by fusing and polycrystallizing hydrogenated amorphous silicon thin film, fine crystalline silicon thin film or the like by laser light or other energy source, among others.

However, when the polycrystalline silicon TFT is fabricated by the conventional method of depositing the polycrystalline thin film directly on the substrate or the method of forming the polycrystalline silicon thin film by solid phase growth of hydrogenated amorphous silicon thin film or the like, the substrate must be heated at least 600 °C more, and hence the substrate to be used in the TFT is limited.

Or, in the forming method of polycrystalline silicon thin film by fusing and polycrystallizing with laser light or other energy source, it is important to keep uniformity of crystalline property and thin film, and fabrication of TFT showing stable characteristic was difficult.

### Summary of the Invention

The invention is intended to offer a manufacturing method which can make transistor characteristics stable ,of the TFT using polycrystalline silicon thin film which is formed by irradiating a excimer laser on the hydrogenated amorphous silicon thin film .

In the present invention the thickness of the hydrogenated amorphous silicon thin film to be fused and crystallined is 500 Å - 1250 Å . Here when the thickness is less than 500 Å, the irradiated laser energy largely affects the layer under the hydrogenated amorphous silicon thin film and when the thickness is more than 1250 Å, the irradiated laser energy does not reach the lowest part of the hydrogenated amorphous silicon thin film to make the characteristics of the lower part of the thin film and that of the upper part different each other. Then by make the thickness of the hydrogenated amorphous silicon thin film 500 Å - 1250 Å , only the hydrogenated amorphous silicon thin film can be uniformly crystallined from the lower part to the upper part of the thin film . Therefore there is a region in which the electric characteristics of the porycrystalline silicon is not affected by energy density of laser.

That is the invention presents a manufacturing method of semiconductor device comprising at least ;
a first step of forming a semiconductor thin film on a light permeable substrate in a specified shape in a film thickness of 500 Å or more and 1250 Å or less,
a second step of emitting laser light to the semiconductor thin film,
a third step of depositing an insulating thin film (a) on the light permeable substrate and semiconductor thin film,
a fourth step of forming an electrode (a) in a specific shape on the insulating thin film (a) ,
a fifth step of injecting impurities into the semiconductor thin film over the insulating thin film (a),
a sixth step of depositing an insulating thin film (b) on thus completed substrate,
a seventh step of forming a hole at a specific position of the insulating thin films (a),(b), and
an eighth step of forming an electrode (b) in a specific shape on the insulating thin film (b).

Further a manufacturing method of semiconductor device of the present invention is characterized by which
said thin film semiconductor to be formed at the first step is composed by depositing a main material gas such as silane (SiH₄) and disilane (Si₂H₆), or a mixed gas of the main material gas and hydrogen gas, at a substrate temperature of 600°C or less by any one of methods of plasma decomposition, thermal decomposition and photodecomposition.

Further a manufacturing method of semiconductor device of the present invention is characterized by which
prior to said second step, said semiconductor thin film is heated at 300°C or more in any one state of ambient atmosphere, vacuum, nitrogen atmosphere, and hydrogen atmosphere.

Further a manufacturing method of semiconductor device of the present invention is characterized by which
after said sixth step, there is a step of hydrogen plasma processing at a substrate temperature of 300 °C or more and 450°C or less.

Further a manufacturing method of semiconductor device of the present invention is characterized by which
said impurities to be injected in the semiconductor layer may be either phosphorus and a compound of phosphorus and hydrogen or boron and a compound of boron and hydrogen, and
there is a heating step for heating at substrate temperature of 300°C or more after injection of the impurities.

Further a manufacturing method of semiconductor device of the present invention is characterized by which
said heating step is said thin film depositing step.

Further a semiconductor device of the present invention is characterized by a first step of forming a hydrogenated amorphous silicon thin film or fine crystalline silicon thin film on a glass substrate in a specific shape in a film thickness of 500 Å or more and 1250 Å or less,
a second step of heating the substrate in vacuum or nitrogen atmosphere at 350°C or more and 450 °C or less,
a third step of fusing and crystallizing the hydrogenated amorphous silicon thin film or fine crystalline silicon thin film by irradiation of excimer laser after heat treatment to form a polycrystalline silicon thin film,
a fourth step of depositing SiO₂, SiNₓ or SiN₂/SiO₂ as a gate insulating film on the glass substrate and polycrystalline silicon thin film,
a fifth step of depositing Cr, Al, Ti, Ta or the like on the gate insulating film as gate electrode to form into a specific shape,
a sixth step of injecting impurities into the polycrystalline silicon thin film over the gate insulating film using the gate electrode as a mask,
a seventh step of depositing SiO₂, SiNₓ or SiNₓ/SiO₂ on the gate insulating film and gate electrode as an interlayer insulating film at substrate temperature of 300°C or more,
an eighth step of forming a hole for contact at a specific position of the gate insulating film and interlayer insulating film,
a ninth step of heating the substrate at 300°C or more after forming the hole for contact to expose to hydrogen plasma, and
a tenth step of depositing Al/Ti, Al, Ti, Cr, Ta or the like on the interlayer insulating thin film as a take-out electrode to form into a specific shape.

By forming a polycrystalline thin film by irradiating with laser light, the polycrystalline silicon thin film can be formed at low temperature (<600°C), so that the range of selecting the substrate is extended.

Moreover, since the film thickness of hydrogenated amorphous silicon thin film or the like to be fused and crystallized is 500 Å or more and 1250 Å or less, in the TFT using the polycrystalline thin film formed subsequently by fusing and crystallizing with laser light irradiation, there is a stable region in the mobility and threshold voltage in a region showing favorable transistor characteristic for laser energy density at the time of irradiation.

### Brief Description of the Drawings

Fig. 1 is a process sectional diagram of part of a manufacturing method of semiconductor device in an embodiment of the invention.

Fig. 2 is a process sectional diagram of the remainder of the manufacturing method of semiconductor device in the embodiment of the invention.

Fig. 3 is a transistor characteristic diagram of a polycrystalline silicon TFT fabricated in an embodiment of the invention.

Fig. 3B is a transistor characteristic diagram of a part of Fig. 3A , for easily explanating Fig. 3A.

Fig. 3C is a transistor characteristic diagram of a part of Fig. 3A , for easily explanating Fig. 3A.

### Preferred Embodiments of the Invention

Referring now to the drawings, an embodiment of the invention is described in detail below.

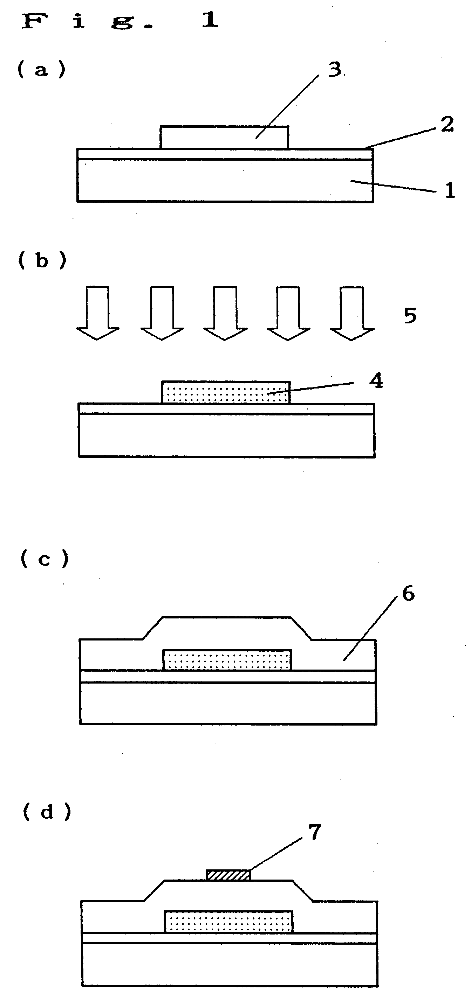

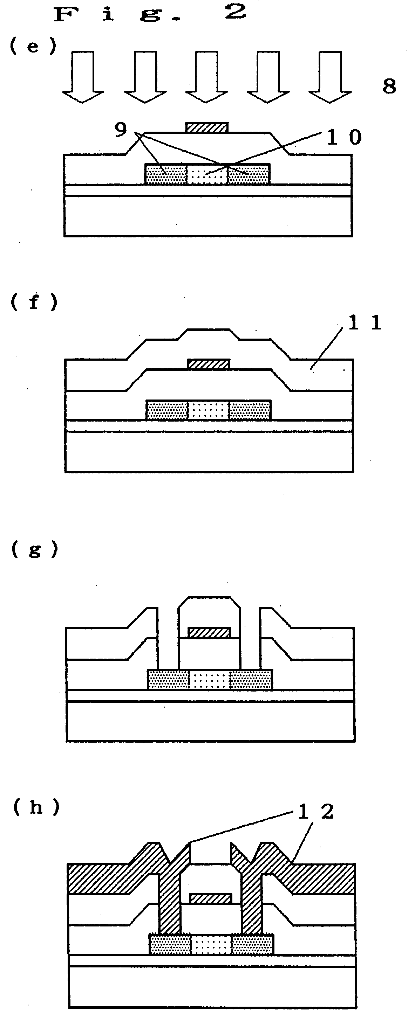

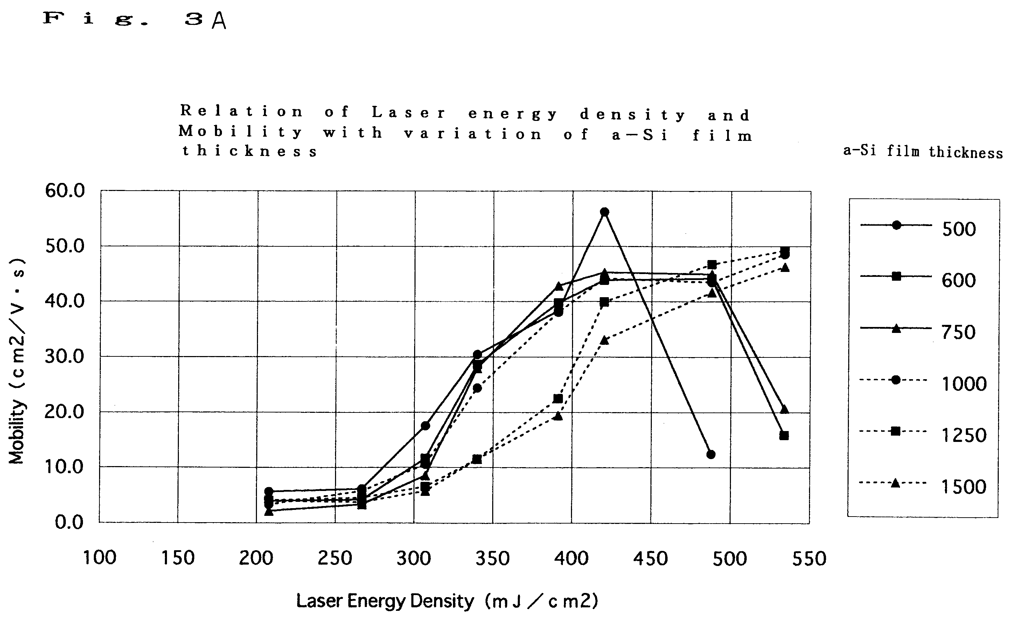

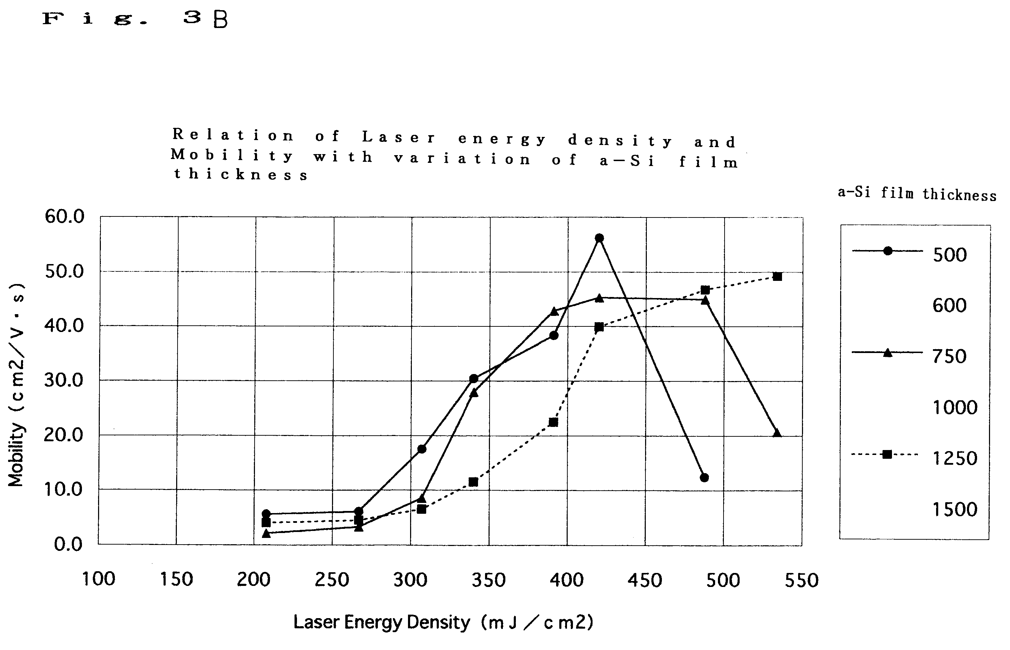

Fig. 1 and Fig. 2 are process sectional diagrams showing a manufacturing method of semiconductor device in an embodiment of the invention. As shown in Fig. 1 (a), a hydrogenated amorphous silicon thin film is deposited on a light permeable substrate 1 in a film thickness of about 1000 Å by plasma CVD method or the like, and is etched in a specific shape to form a hydrogenated amorphous silicon semiconductor layer 3. A glass substrate or the like is used as the light permeable substrate 1. As the semiconductor layer 3, a fine crystalline silicon thin film or polycrystalline thin film may be used. The semiconductor layer 3 formed herein is heated in a nitrogen atmosphere of 0.1 to scores of Torr, at substrate temperature of 350 to 450°C, for 30 to 180 minutes, and hydrogen atoms or hydrogen molecules contained in the semiconductor layer 3 are eliminated. This is intended to eliminate hydrogen slowly in advance i order to prevent bumping due to sudden elimination of hydrogen when fusing and crystallizing by laser light irradiation in the subsequent process. However, if the hydrogen content when depositing the semiconductor layer 3 is up to 5 atomic % or less, such heat treatment may be omitted. Heating may be conducted either in vacuum or in ambient atmosphere.

Consequently, as shown in Fig. 1 (b), an excimer laser (for example, XeCl, KrF, etc.) light 5 is emitted to the light permeable substrate, and the hydrogenated amorphous silicon semiconductor layer 3 is formed into a polycrystalline silicon semiconductor layer 4. The laser energy density at this time is in a range of 200 to 600 mJ/cm2.

Next, as shown in Fig. 1 (c), as a gate insulating film 6, SiO₂ is deposited on the light permeable substrate in a thickness of about 100 to 500 Å by atmospheric CVD apparatus. As the gate insulating film, at this time, aside from a single layer of SiO₂, two layers of SiO₂, a single layer of SiNₓ, or two layers of SiO₂ and SiNₓ may be formed. As the depositing method, in addition, the LP-CVD apparatus, plasma CVD apparatus, photo CVD apparatus, ECR-SP apparatus, ECR-plasma CVD apparatus, and the like may be considered.

As shown in Fig. 1 (d), as a gate electrode 7, Cr (chromium) is deposited about 500 to 4000 Å, and is etched in a specific shape. As the electrode material, at this time, Al, polycrystalline silicon, Ta, Ti, etc. may be used.

Further, as shown in Fig. 2 (e), B2H6 or PH3 diluted in hydrogen is decomposed and activated by plasma, and accelerated by electric field, and impurities are injected, and by this non-mass separation type doping method, impurities are injected into the semiconductor layer 4 over the gate insulating film 6, and a source-drain region 9 is formed. At this time, the gate electrode 7 and gate insulating film 6 function as the mask, and impurities are not injected into a channel region 10, so that the source-drain region 9 may be formed by self-alignment.

As shown in Fig. 2 (f), as an interlayer insulating film 11, SiO₂ is deposited on the substrate by about 100 to 5000 A by atmospheric CVD apparatus. As the interlayer insulating film 11, at this time, aside from a single layer of SiO₂, two layers of SiO₂, a single layer of SiNₓ, or two layers of SiO₂ and SiNₓ may be formed. As the depositing method, in addition, the LP-CVD apparatus, plasma CVD apparatus, photo CVD apparatus, ECR-SP apparatus, ECR-plasma CVD apparatus, and the like may be considered. The substrate temperature when depositing is 450°C or less. Moreover, if the substrate temperature when depositing is around 400°C, activation after impurity injection can be conducted simultaneously, and the activation process can be simplified.

Next, as shown in Fig. 2 (g), a hole for taking out the electrode is formed in a specified position of the gate insulating film 7 and interlayer insulating film 11. After forming this hole, at the substrate temperature of 300 to 400°C, the substrate is exposed to hydrogen plasma atmosphere for about 10 to 240 minutes. By this treatment, dangling bonds existing in the grain boundary of the polycrystalline silicon thin film being fused and crystallized are terminated by hydrogen atoms, thereby enhancing the electric characteristic. This hydrogen plasma treatment may be conducted after depositing the interlayer insulating film. Furthermore, in the process after hydrogen plasma treatment, each process is conducted at the substrate temperature of 350°C or less. This is intended to prevent re-elimination of the terminated hydrogen atoms by setting the substrate temperature over 350°C. Finally, as shown in Fig.2(h), a source-drain electrode 12 is formed in a specific shape.

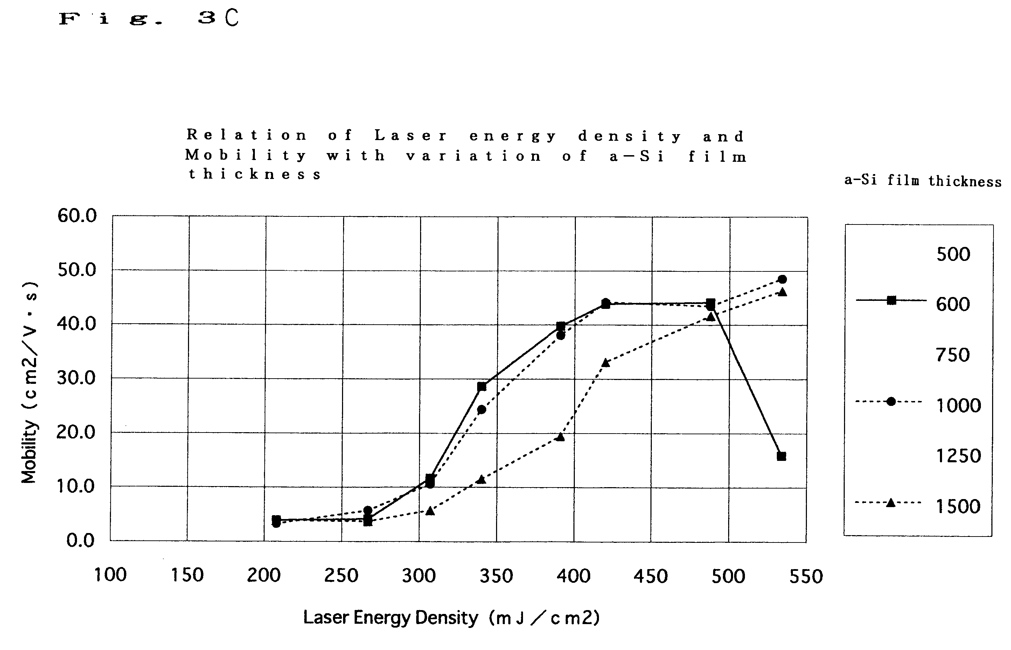

Figs. 3A,3B,3C show the relation of the laser energy density and mobility of the p-ch polycrystalline silicon TFT fabricated by depositing a hydrogenated amorphous silicon thin film in a film thickness of 500, 600, 750, 1000, 1250 and 1500 Å by plasma CVD apparatus. Meawhile Fig. 3B is a transistor characteristic diagram of a part of Fig. 3A , for easily explanating Fig. 3A and Fig. 3C is a transistor characteristic diagram of a part of Fig. 3A , for easily explanating Fig. 3A. The drain voltage is 12 V, and W/L is 48 µm/12 µm. The transistor fabricating method is as shown in Figs. 1 and 2, and the manufacturing conditions at this time are shown in Table 1.

**Table 1**

| Process | Treating condition | |
|---|---|---|
| Hydrogenated amorphous silicon thin film | Substratetemperature: 270°C | |
| | Film thickness: | 500 Å |
| | | 600 Å |
| | | 750 Å |
| | | 1000 Å |
| | | 1250 Å |
| | | 1500 Å |
| Hydrogen eliminating treatment | Substrate temperature: 400°C | |
| | Treatingtime: 90 min | |
| Fusing and crystallizing | XeCl laser | |
| Gate insulating film: SiO₂ | Substrate temperature: 420°C | |
| | Film thickness: 2000 Å | |
| Gate electrode: Cr | Film thickness: 2000 Å | |
| Impurity doping: B₂H₆/H₂ (non-mass separation doping method) | Acceleration voltage: 60 kV | |
| | Dose: 5 × 10¹⁵/cm² | |
| Interlayer insulating film: SiO₂ | Substrate temperature: 420°C | |
| | Film thickness: 2000 Å | |
| Hydrogen addition treatment (by hydrogen plasma) | Substrate temperature: 300°C | |
| | Treating time: 90 min | |
| Take-out electrode: Al/Ti (source-drain) | Film thickness Ti: 1000 Å | |
| | Film thickness Al: 5000 Å | |

As shown in Figs. 3A,3B,3C, at the film thickness of the hydrogenated amorphous silicon thin film of 600 Å - 1000 Å, there is a stable region not depending on the laser energy density near the peak of the mobility. Yet, at 1250 Å, the laser energy density where the mobility reaches nearly to the peak is as high as 500 mJ/cm² or more, and hence the efficiency of crystallization is poor. Accordingly, by defining the film thickness of hydrogenated amorphous silicon thin film at 500 Å or more and 1250 Å or less, it is possible to fabricate a polycrystalline silicon TFT possessing a stable region of transistor characteristic, and excellent in the efficiency of crystallization.

As clear from the description herein, the invention possesses the following effects.
(1) By fusing and crystallizing a semiconductor thin film (hydrogenated amorphous silicon thin film, or the like) by laser light to form polycrystalline silicon, low temperature (<600°C) process is enabled, and the range for selecting the substrate is extended.
(2) By defining the film thickness of the semiconductor thin film to be fused and crystallized (hydrogenated amorphous silicon, or the like) at 500 Å or more and 1250 Å or less, the stability and uniformity of the characteristics of the fabricated transistor may be enhanced.
(3) When activating the impurities injected in the semiconductor layer by heating the substrate at the time of deposit of thin film, the process of activation may be simplified.

## Claims

1. A manufacturing method of semiconductor device comprising ;
a first step of forming a semiconductor thin film on a light permeable substrate in a specified shape in a film thickness of 500 Å or more and 1250 Å or less,
a second step of emitting laser light to the semiconductor thin film,
a third step of depositing an insulating thin film (a) on the light permeable substrate and semiconductor thin film ,
a fourth step of forming an electrode (a) in a specific shape on the insulating thin film (a) ,
a fifth step of injecting impurities into the semiconductor thin film over the insulating thin film (a),
a sixth step of depositing an insulating thin film (b) on thus completed substrate,
a seventh step of forming a hole at a specific position of the insulating thin films (a),(b), and
an eighth step of forming an electrode (b) in a specific shape on the insulating thin film (b).

2. A manufacturing method of semiconductor device of claim 1, wherein
the thin film semiconductor to be formed at the first step is composed by depositing a main material gas such as silane (SiH₄) and disilane (Si₂H₆), or a mixed gas of the main material gas and hydrogen gas, at a substrate temperature of 600°C or less by any one of methods of plasma decomposition, thermal decomposition and photodecomposition.

3. A manufacturing method of semiconductor device of claim 1, wherein
prior to the second step, said semiconductor thin film is heated at 300°C or more in any one state of ambient atmosphere, vacuum, nitrogen atmosphere, and hydrogen atmosphere.

4. A manufacturing method of semiconductor device of claim 1, wherein
after the sixth step, there is a step of hydrogen plasma processing at a substrate temperature of 300 °C or more and 450°C or less.

5. A manufacturing method of semiconductor device of claim 1, wherein
the impurities to be injected in the semiconductor layer may be either phosphorus and a compound of phosphorus and hydrogen or boron and a compound of boron and hydrogen, and
there is a heating step for heating at substrate temperature of 300°C or more after injection of the impurities.

6. A manufacturing method of semiconductor device of claim 5, wherein
the heating step is said thin film depositing step (the sixth step ).

7. A thin film transistor manufactured through:
a first step of forming a hydrogenated amorphous silicon thin film or fine crystalline silicon thin film on a glass substrate in a specific shape in a film thickness of 500 Å or more and 1250 Å or less,
a second step of heating the substrate in vacuum or nitrogen atmosphere at 350°C or more and 450 °C or less,
a third step of fusing and crystallizing the hydrogenated amorphous silicon thin film or fine crystalline silicon thin film by irradiation of excimer laser after heat treatment to form a polycrystalline silicon thin film,
a fourth step of depositing SiO₂, SiNₓ or SiN₂/SiO₂ as a gate insulating film on the glass substrate and polycrystalline silicon thin film,
a fifth step of depositing Cr, Al, Ti, Ta or the like on the gate insulating film as gate electrode to form into a specific shape,
a sixth step of injecting impurities into the polycrystalline silicon thin film over the gate insulating film using the gate electrode as a mask,
a seventh step of depositing SiO₂, SiNₓ or SiNₓ/SiO₂ on the gate insulating film and gate electrode as an interlayer insulating film at substrate temperature of 300°C or more,
an eighth step of forming a hole for contact at a specific position of the gate insulating film and interlayer insulating film,
a ninth step of heating the substrate at 300°C or more after forming the hole for contact to expose to hydrogen plasma, and
a tenth step of depositing Al/Ti, Al, Ti, Cr, Ta or the like on the interlayer insulating thin film as a take-out electrode to form into a specific shape.
